# EUROPEAN PATENT APPLICATION

(11) **EP 3 886 185 A1**
(43) Date of publication of application: **29.09.2021**
(21) Application number: 20166232.7
(22) Date of filing: 27.03.2020
(51) Int. Cl.: H01L 31/0745, H01L 31/0747, H01L 31/18, H01L 31/20

(54) **PHOTOVOLTAIC DEVICE AND METHOD FOR MANUFACTURING THE SAME**

(71) Applicant: Meyer Burger GmbH, 09337 Hohenstein-Ernstthal (DE)
(72) Inventor: Lachenal, Damien, 2016 Cortaillod (CH)
(74) Representative: Bovard SA Neuchâtel

(57) **Abstract**

The invention relates to an interdigitated back contact (IBC) photovoltaic device (1), comprising:a silicon-based substrate (3), an intrinsic amorphous silicon layer a-Si:H(i) (5) situated on substrate (3) a first patterned silicon layer (2), and a second patterned nano-crystalline silicon layer (4) on the first patterned silicon layer (2). The second patterned layer (4) is of the same type of doping than said first patterned silicon layer (2) The first patterned layer (2) and the second patterned layer (4) form photovoltaic structures (12a, 12g), of which at least one constitutes a fiducial mark (10) having, in a predetermined wavelength range, a different optical reflectivity (R1), than the reflectivity (R0) of the intrinsic amorphous silicon (a-Si:H(i)) layer portions interstices (5a-5f) between said photovoltaic structures (12a, 12g).

The invention relates also to a solar cell comprising said photovoltaic device (1), and to a method of fabrication of said photovoltaic device.

## Description

### Technical Field

The present invention relates to the field of photovoltaic devices. More particularly, it relates to a photovoltaic device with back-contacts being of the interdigitated back contact (IBC) type in which the collecting material is patterned. The invention relates particularly to devices comprising a tunnel junction on the back of the device. The invention also relates to a method for producing such photovoltaic devices.

A particular advantageous application of the present invention is for the production of highly efficient photovoltaic cells intended for generating electrical energy, but the invention also applies, more generally, to any similar device in which an incoming radiation is converted into an electrical signal, such as photodetectors and ionizing radiation detectors.

### Background of the invention

Interdigitated back-contact silicon heterojunction solar cells (IBC-SHJ), while being highly efficient, present difficulties due to their highly complex processing. Indeed, the realization of IBC-SHJ devices requires patterning the rear a-Si:H layers and TCO/metal stacks into interdigitated combs, with a very high accuracy. Most of the techniques known from the state-of-the-art rely on the use of complex and costly processes. Examples are described in for example the following papers:
- *Efficient interdigitated back-contacted silicon heterojunction solar cells,* N.Mingirulli et al, Phys.status solidi-Rapid Res.Lett., vol.5, nr.4, pp.159-161, Apr. 2011;
- *The role of back contact patterning on stability and performance of Si IBC heterojunction solar cells,* U.K.DAS et al., Proceedings of the 40the IEEE Photovoltaic Specialist Conference, 2014, vol.1;

One of the outstanding difficulties of the known processes to make IBC solar cells such as tunnel junction IBC photovoltaic devices, especially in high volume production machines, is related to the use of commonly known standard alignment techniques to align deposition masks and a wafer during the PECVD step. Known alignment techniques in the field of interdigitated back-contact silicon heterojunction solar cells rely solely on the need of an absolute mask-to-wafer positioning. Such alignment techniques require a very high accuracy, i.e. better than 5 µm, leading to a severe limitation of the mask alignment automation, especially under vacuum environment. Current alignment techniques impose slow processes to be highly accurate and need expensive and optical alignment tools, limiting severely the production throughput. The required high accuracy of better than 5µm when positioning several masks for different process steps is also a source of loss of production yield.

### Summary of the invention

The present invention proposes to improve commonly known standard alignment techniques to align deposition masks and a wafer during the PECVD step of the fabrication of photovaltaic cells. Therefor, the invention provides fiducial marks that avoid current alignment techniques which rely solely on the need of an absolute mask-to-wafer positioning. The invention as described herein is about how to provide novel and improved fiducial marks that enable the visibility of the fiducial, in reflection and/or in transmission, in the PECVD step for later processing even if the fiducial mark is made of the same material as the base substrate and at the same time very thin!

In a first aspect the invention relates to a photovoltaic device, being an interdigitated back contact (IBC) comprising:
- a silicon-based substrate being of p-type or n-type doping and having a first face defining a horizontal X-Y plane and a vertical direction Z orthogonal to said horizontal X-Y plane;
- an intrinsic amorphous silicon layer a-Si:H(i) situated on said first face ;
- a first patterned silicon layer, situated on said intrinsic amorphous silicon layer a-Si:H(i) layer, comprising a first array of distinct and separated amorphous layer islands so that between the amorphous layer islands non-coated, intrinsic amorphous silicon (a-Si:H(i)) layer portions are provided that define an array of interstices, said first patterned silicon layer having the same doping as the doping of the silicon-based substrate,

A second patterned nano-crystalline silicon layer is in contact with said first patterned silicon layer, comprising a second array of second layer portions, each of said second layer portions being in contact with one of said first layer portions and forming an array of photovoltaic structures.

A second array of second layer portions is of the same type of doping than said first patterned silicon layer,

At least one of said photovoltaic structures constitutes a fiducial mark having, in a predetermined wavelength range, a different optical reflectivity R1, defined to the side away from said substrate, than the reflectivity R0 of said intrinsic amorphous silicon (a-Si:H(i)) layer portions. said fiducial mark may have also a different optical transmittivity T1 than the transmittivity T0 of said intrinsic amorphous silicon (a-Si:H(i)) layer portions, said optical transmissivity (T1).

In an embodiment the absolute value of (R1-R0)/R0 is between 0.001 and 0.5, preferably between 0.005 and 0.1, more preferable between 0.09 and 0.2 for at least one wavelength, R0 and R1 being defined for wavelengths between 300nm and 1000nm.

In an embodiment the photovoltaic device comprising at least two fiducials.

In an embodiment at least one of said fiducials has a different shape and/or or different dimension, in at least one cross section plane (XY, YZ, XZ), than the shape and/or the dimension of said electric charge collecting structures.

In an embodiment a third silicon doped layer having an opposite doping of the layer first patterned silicon layer and said and.

In an embodiment the photovoltaic device comprises at least 2 fiducial marks having a different shaped cross section in at least one plane parallel to said horizontal X-Y plane.

In an embodiment an additional silicon layer is present on said second patterned nano-crystalline silicon layer, covering said photovoltaic structures and said interstices , said additional silicon layer having a doping of the other type than the first patterned silicon layer, the mesa on said at least one fiducial having a reflectivity R3 than the reflectivity of said interstices R2 so that and wherein said at least one fiducials are optically detectable by optical means through said additional silicon layer.

In an embodiment a transparent and conductive second layer, is present on said additional silicon layer, covering said mesas and said third layer interstices, so that the at least one coated fiducial has a reflectivity R5 different than the reflectivity R4 of its surroundings and so that said at least one coated fiducial is optically detectable by optical means through said additional silicon layer and said second full area layer.

The invention is also achieved by photovoltaic cell comprising the photovoltaic device as described.

The invention is also achieved by a method for manufacturing of a photovoltaic device as described, comprising the steps **(a-d)** of:
**a.** providing a silicon-based substrate having an n-type or a p-type doping and comprising an intrinsic amorphous a-Si:H(i) layer situated on a first face of said silicon-based substrate;
**b**. realizing, on predetermined areas of said intrinsic layer, a first deposition of an n-type or p-type amorphous silicon layer, so as to create a patterned amorphous silicon layer comprising a plurality of distinct and separated amorphous layer islands separated by interstices;
**c.** realizing on each of said amorphous layer islands a second deposition of a nano-crystalline layer having the same doping type as said amorphous layer, so as to create on top of each of said amorphous layer islands, nano-crystalline layer portions, to form an array of photovoltaic structures, while choosing the thickness (t) of said first amorphous layer portions so that at least one fiducial is formed that has a different optical reflectivity (R1), defined to the side away from said substrate, than the reflectivity (R0) of the said intrinsic amorphous silicon (a-Si:H(i)) layer portions.

In an embodiment, after step c, **a step d** is performed consisting in depositing, on top of the photovoltaic structures said intrinsic amorphous silicon (a-Si:H(i)) layer portions, a full area semiconductor layer, having a doping type different than the doping type of said second nano-crystalline layer so that said at least one fiducial may be detected by optical means through said full area semiconductor layer

In an embodiment, after said **step d,** a **step e** is realized consisting in depositing a second layer on top of said semiconductor layer and so that said at least one fiducial may be detected by optical means through said full area semiconductor layer and second full area layer.

In an embodiment the thickness t2 of said second layer is chosen so that, by constructive interference, reflected light off said at least one fiducial is transmitted through said second layer, in at least one wavelength range defined in the UV, visible or infrared optical spectrum.

In an embodiment the realization of said at least one fiducial is made by using a mask comprising at least one conical shape aperture, said conical shape being defined in at least one plane orthogonal to said horizontal X-Y plane and so that at least one fiducial has a greater height (h) than said electric charge collection structures.

In an embodiment the deposition of said amorphous layer islands and the deposition of the nanocrystalline layer islands are made through the same mechanical mask.

### Brief description of the drawings

The present invention will now be described in reference to the enclosed drawings where:
- Fig. 1: is a schematic cross-section view of a portion of a photovoltaic device of the invention comprising fiducials each made of a portion of a-Si:H(n) layer and a portion of a nc-si:H(n) layer. The figure also illustrates an array of electric charge collecting structures;
- Fig.2: is a schematic cross-section view of a fabrication step of a portion of a photovoltaic device, illustrating a mechanical shadow mask for realizing an optical detectable fiducial realized by the superposition, through the mask, of a portion of a a-Si:H(n) layer and a portion of a nc-si:H(n) layer;
- Fig. 3: is a schematic cross-section view of an embodiment of a fabrication step of a portion of a photovoltaic device, illustrating a mechanical shadow mask for realizing an optical detectable fiducial realized by the superposition, through the mask, of a portion of a a-Si:H(n) layer and a portion of a nc-si:H(n) layer, the mask layer comprising two conical shaped apertures;
- Fig.4: is a top view of a portion of a photovoltaic device of the invention comprising two fiducials each made of a portion of a-Si:H(n) layer and a portion of a nc-si:H(n) layer. The figure also illustrates an array of electric charge collecting structures;
- Fig. 5: is a top view of a portion of a photovoltaic device comprising two fiducials and an array of charge collecting structures that are covered entirely by a first, preferably full, area layer that has an opposite doping than the doping of the substrate of the photovoltaic device;
- Fig. 6: illustrates a top view of a portion of a photovoltaic device comprising a second area layer, possibly a full area layer, made of for example ZnO:Al, covering entirely the first full area layer of Fig.5. Fig.6 illustrates that the fiducial marks of the invention are optically detectable through said second full area layer, and are used to patterned a conductive and transparent layer as illustrated in the Fig.8;
- Fig.7: illustrates a cross section view of the photovoltaic device of Figure 5, demonstrating the difference in reflectivities of the fiducials and its interstices. Fig.7 illustrates the state of realization of a photovoltaic device before deposition of an area conductive and transparent layer, that may be a full area layer. The alignment fiducials in Fig.5 are used to realize a patterned conductive and transparent layer as illustrated in the next Fig.8;
- Fig.8: illustrates a typical realization of a back-contact of the device of the invention, prior the final metallization step. Fig.8 shows a conductive and transparent layer after the patterning step of a full area conductive and transparent layer by using the alignment fiducials of the invention;
- Fig.9: illustrates another realization of a back-contact of the device of the invention;
- Fig.10: illustrates reflectivities and transparencies from and through fiducials of the invention that are coated with a layer having a doping opposite of the doping of the fiducials;
- Fig.11: illustrates reflectivities and transparencies from and through fiducials of the invention that are coated with a transparent and conductive layer;
- Fig.12: illustrates the difference in reflectivity of a photovoltaic device on top of a fiducial mark of the invention, comprising an amorphous a-Si:H(n) layer and of the area beside that fiducial that has no a-Si:H(n) layer. The reflectivity curves of Fig.10 demonstrates the benefit of using a layer of a-Si:H(n) in the fiducial of the invention, to enhance the contrast in the case of a typical visible spectrum;
- Fig.13: illustrates the transmission difference between fiducials that comprise an amorphous a-Si:H(n) layer and a fiducial that does not comprise an amorphous a-Si:H(n) layer.

### Detailed description

The present invention will be described with respect to particular embodiments and with reference to certain drawings, but the invention is not limited thereto. The drawings described are only schematic and are non-limiting. In the drawings, the size of some of the elements may be exaggerated and not drawn on scale for illustrative purposes. The dimensions and the relative dimensions do not correspond to actual reductions to the practice of the invention.

It is to be noticed that the term "comprising" in the description and the claims should not be interpreted as being restricted to the means listed thereafter, i.e. it does not exclude other elements.

Reference throughout the specification to "an embodiment" means that a feature, structure or characteristic described in relation with the embodiment is included in at least one embodiment of the invention. Thus, appearances of the wording "in an embodiment" or, "in a variant", in various places throughout the description are not necessarily all referring to the same embodiment, but several. Furthermore, the features, structures or characteristics may be combined in any suitable manner, as would be apparent to a skilled person from this disclosure, in one or more embodiments. Similarly, various features of the invention are sometimes grouped together in a single embodiment, figure or description, for the purpose of making the disclosure easier to read and improving the understanding of one or more of the various inventive aspects. Furthermore, while some embodiments described hereafter include some, but not other features included in other embodiments, combinations of features if different embodiments are meant to be within the scope of the invention, and from different embodiments. For example, any of the claimed embodiments can be used in any combination. It is also understood that the invention may be practiced without some of the numerous specific details set forth. In other instances, not all structures are shown in detail in order not to obscure an understanding of the description and/or the figures.

A horizontal plane herein is defined as a X-Y plane parallel to a face of the substrate 3. The wording "horizontal cross section means a cross section in a X-Y plane. The wording "vertical means" here perpendicular to the substrate and defines a Z-axis. A vertical cross section is a cross section in a X-Z or Y-Z plane that comprises the vertical axis Z. A radial direction means a direction defined in a horizontal cross section. A lateral direction is defined in an X and/or Y direction in a horizontal plane. A width is defined as a width of a structure across a virtual line in a horizontal plane., said width is also defined as a diameter. Thicknesses are defined herein as thicknesses in the vertical Z-direction.

The term "fiducial" herein means an alignment mark, also defined as a fiducial mark 10, 10'.

The term "full area layer" used herein is defined as a layer deposited on a whole surface, for example of a whole substrate 3.

The invention provides an IBC solar cell, such as a tunnel-junction IBC photovoltaic devices that can be produced with a low-cost process especially in high volume production machines. The method and devices of the invention improves current alignment techniques which rely solely on the need of an absolute mask-to-wafer positioning. Such alignment techniques require a very high accuracy, i.e. better than 5 µm, leading to a severe limitation of the mask alignment automation. Furthermore, the mask alignment better than 5 µm in a high throughput PECVD machine (>6000 wafers per hour) remains a complex problem considering the global environment. Especially, the deposition temperature (150°C-250°C) leads to material dilatations (mask, wafer holder) and the vacuum environment prevents the use of low-cost alignment technics such as standard cameras. These constraints impose slow processes and require expensive optical alignment tools, limiting severely the production throughput. The required high accuracy of better than 5µm is also a source of loss of production yield. It is therefore needed to find an alternative solution allowing the alignment preferably at room temperature, in a standard atmosphere (i.e. not under vacuum) and at a high speed to decrease the global manufacturing cost of such a solar cells.

The invention as described herein is about how to make or better deposit fiducials 10 to enable visibility of the fiducial in the PECVD step for later processing even if the fiducial mark 10 is made of the same material as the base substrate and at the same time very thin!

The proposed solution solves the problem of expensive mask and wafer automation by postponing the alignment procedure between the silicon N and P junctions and the final metallization step in the following way.

Instead of an accurate mask to wafer positioning better than 5 µm using a standard wafer edge alignment method at the PECVD step, the solution relaxes the alignment constraint to a range of 300 µm - 500 µm by the use of fiducial openings integrated into the required mask. By doing so, the mask positioning is relaxed and can be done in a passive way without camera, decreasing considerably the automation cost. Next, the metallization step, which needs to be aligned with the previous deposited silicon N & P junctions is done with standard screen-printing machines. These machines, mostly equipped with cameras working in the visible wavelength range, easily align within an accuracy of 5µm and at high throughput as soon as they are capable to recognize, at least, a pair of fiducials, or a fiducial having a specific shape on the wafer. The novelty and inventive aspect resides in the fact that the fiducial material composition is done during the PECVD step, so that for example a screen printer machine is able to recognize the fiducial(s) 10 and enable to align the metallization screen on previously deposited N and P silicon junctions.

An efficient tunnel junction, in a back contacted solar cell application, is made typically of an N-type doped nano-crystalline silicon layers deposited through a mask, and a -P-type doped nano-crystalline silicon layer that forms at the same time the tunnel junction itself (N polarity) and the emitter layer (P polarity). For efficient production the second, p-type doped layer, is deposited without a mask and hence covering both, the localized and structured n-type layer, as well as the interstices between these structures. Both, p- and n-type layers, embed a high fraction of silicon crystals at the nano-meter scale, within a thickness layer of 30-80nm. These N and P layers are optically very close to the optical index (n, k) of the also crystalline silicon bulk wafer 3. The addition of an intrinsic, amorphous silicon layer a-Si:H(i) 5 ,typically used as an effective passivation layer in heterojunction based solar cells is not sufficient to guarantee an effective optical separation of the mostly nano-crystalline structures from the crystalline substrate due to its thickness of typically less than 10nm. It is therefore impossible, if done in that way, to detect any optical difference between the pattern of the P and N polarities with the common screen printer cameras, as both layers are made of the same crystalline silicon composition. The invention consists in solving this technical problem by providing a new type of fiducial marks10.

The novelty and inventive step, proposed in this invention, has been to develop a material composition of the fiducials, so that their optical indices are significantly different compared to the bulk silicon wafer - coated with an intrinsic a-Si:H(i) amorphous silicon layer - without degrading the electrical performance of the tunnel junction itself. By implementing the solution of the invention, a solar cell efficiency can reach its best performance and can be aligned with standard screen printer machines at room temperature and at atmospheric pressure, enabling the manufacturing of such IBC solar cells at low cost.

Practically, by depositing an n-doped amorphous silicon layer 2 prior to the n-doped nano-crystalline layer through the mask, alignment marks are provided that become visible to printer cameras that mostly work in the visible wavelength range. The use of such an amorphous layer 2 enhances the contrast between the silicon wafer 3 and the fiducials 10 as their optical properties η(λ), k(λ) differ. Physically, the optical index of the localized fiducials of the invention are made of a stack of layers that are successively nano-crystalline(p), nano-crystalline(n), amorphous-silicon(n), amorphous-silicon(i), substrate 3, while the surrounding area of the fiducials is made of nano-crystalline(p)/amorphous silicon(i)/substrate 3 material. The change in reflectivity of the fiducials 10 is also achieved by adjusting the thickness of the structured amorphous silicon layer 2.

The n-doped amorphous silicon layer 2 being thin (5-15nm range), the electrical transport through this layer is not degraded and the electrical performance of the tunnel junction is maintained. The novelty and inventive step of the solution of the invention resides in the fact that reflectivity of the deposited silicon layer is modified locally through the shadow mask compared to the silicon bulk wafer without increasing the electrical resistance of the tunnel junction.

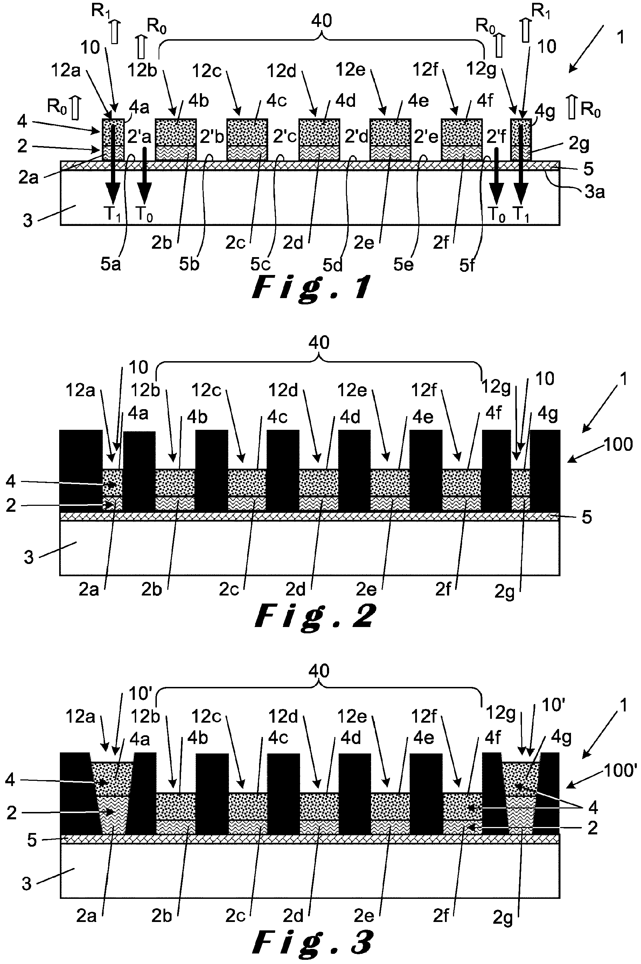

More precisely the invention proposes a photovoltaic device 1, being an interdigitated back contact (IBC) which comprises:
- a silicon-based substrate 3 being of p-type or n-type doping and having a first face 3a defining a horizontal X-Y plane and a vertical direction Z orthogonal to said horizontal X-Y plane;
- an intrinsic a-Si:H(i) amorphous silicon layer 5 situated on said first face 3a;
- a first patterned silicon layer 2, situated on said intrinsic a-Si:H(i) amorphous silicon layer 5, comprising a first array of distinct and separated amorphous layer islands 2a-2g. These amorphous layer islands 2a-2g are separated by an array 2' of interstices 2a'-2g'. In these interstices, which are apertures of the first patterned silicon layer 2, intrinsic amorphous silicon (i.e. a-Si:H(i)) layer portions 5a-5f, defined also as interstitial portions 5a-5f, are present, which are the portions of the amorphous silicon layer 5 on which there are no amorphous layer portions. Said first patterned silicon layer 2 has the same doping as the doping of the silicon-based substrate 3,
- a second patterned nano-crystalline silicon layer 4 in contact with said first patterned silicon layer 2, comprising a second array of second layer portions 4a-4g, each of said second layer portions 4a-4g being in contact with one of said first layer portions 2a-2g and forming an array 40 of photovoltaic structures 12a-12g, as illustrated in Fig.1. Most 12b-12f of the photovoltaic structures are charge collecting structures and the remaining structures 12a, 12g are alignment marks or are charge collecting structures that are used as alignment marks. There is at least one photovoltaic structure 12a that is used as an alignment mark or is an alignment mark. As explained further the structures used as alignment mark may be different in shape, composition or have a different coating than the charge collecting structures 12b-12f. As explained further, alignment marks may have the shape of dots or may present a form that allows to defined directions in the X-Y plane such as an L-shaped form or other.
It is understood that the second layer portions 4a-4g -might not have the same lateral dimensions as the lateral dimensions of said amorphous layer islands 2a-2g

Said second array of second layer portions 4a-4g is of the same type of doping than said first patterned silicon layer 2. In embodiments the level of doping of second layer portions 4a-4g may be different than the level of doping of said first patterned silicon layer 2.

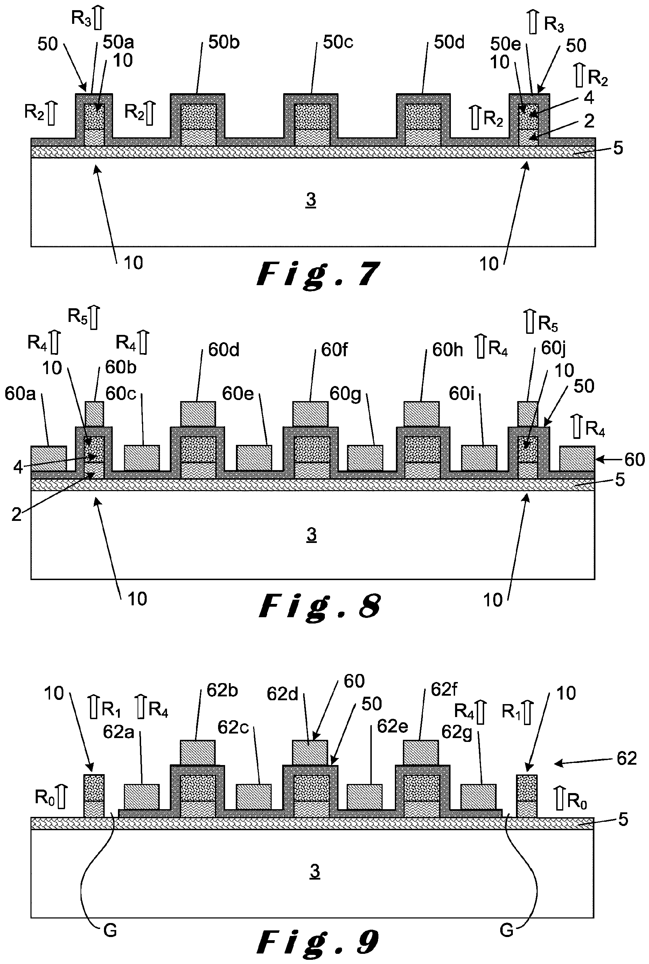

At least one of said photovoltaic structures 12a, 12g constitutes a fiducial mark 10 having an optical reflectivity R1, defined to the side away from said substrate 3, that is different than the reflectivity R0 of said intrinsic amorphous silicon (i.e. a-Si:H(i)) layer portions 5a-5f as illustrated by the respective symbols RO and R1 in Fig.1 and in an embodiment illustrated in Fig.9, at least in a certain wavelength rage.

In an embodiment, the optical reflectivity R1 of the fiducial marks 10 may be greater or smaller than the reflectivity R0 of the interstitial portions 5a-5f of the intrinsic amorphous layer 5.

In embodiments the absolute value of (R1-R0)/R0 may be between 0.001 and 0.5, preferably between 0.005 and 0.1, more preferable between 0.09 and 0.2, the reflectivities R0 and R1 being defined for a wavelength range between 300nm and 1000nm. In practice, a difference of some % between the values of R1 and R0 is sufficient to provide optical detection of the presence of the fiducial marks 10, 10' in the device 1 of the invention Without the composition of an amorphous layer portion 2a, 2g and a nano-crystalline layer portion 4a, 4g, as illustrated in Fig.1 the photovoltaic structures 12a, 12g, that constitute fiducial marks 10, the alignment with other parts would not be possible. Such other part may be :
- electrical contact structures
- masking structures/layers to protect deposited layers from a partial back etch or to avoid local short circuits during further processing steps (i.e. interconnections by wires or ribbons).

Indeed, the index of refraction may be adapted so that the reflectivity of the fiducial marks 10 may be adapted to provide a great contrast with the surrounding intrinsic amorphous layer portions 5a-5f.

Typically, the first layer portions 2a-2g have a diameter of 500 µm to 1mm and thickness between 5nm to 30nm. The thickness of the second layer portions 4a-4g is between 15nm to 80nm.

It is understood that the invention is not limited to the exemplary value ranges of R1 and R0 as explained above.

In the device of the invention all photo voltaic structures are electrically conductive. The fiducials marks 10 are electrically conductive because of the used process. In embodiments, an electrical isolation layer may be arranged between the intrinsic amorphous layer 5 and the fiducials 10, i.e. between the intrinsic amorphous layer 5 and the amorphous fiducial portions 2a, 2g.

In particular embodiments, in view of enhancing the optical contrast between the fiducials and their surrounding layers, such as the intrinsic amorphous layer portions 5a-5f, the fiducials may incorporate materials that are not present in the other photovoltaic structures 12b-12f. For example, ion implants may be realized in said fiducials 10 and not in the other photovoltaic structures 12b-12f. Also, in variants, the crystal and/or structural matrix composition of the fiducials 10 may be different, at least partially, than the other photovoltaic structures 12b-12f.

In variants, not illustrated, an additional contrast layer may be deposited only at the site of the fiducials 10 and not on the other photovoltaic structures 12b-12f. In a variant said optical contrast layer may be realized by a laser treatment, at least partially inside the volume of the fiducials 10, or by treating its upper surface to the side away from said substrate 3. In a variant, for example, a thermal and/or or laser treatment may alter the surface roughness of the fiducials to create a different optical reflection property than the reflection properties of the other photovoltaic structures 12b.12f.

In an embodiment, the photovoltaic device 1 comprises at least two and possibly different fiducials 10, 10'. For example, the photovoltaic device 1 may comprise 3 fiducial marks arranged in the form of a triangle, or may comprise a great number of fiducial marks that may be arranged according to an array that present a form dependent of the layout of the charge collecting structures, for example a circular, a square or a rectangular layout form.

In an embodiment, at least one of said fiducials 10,10' has a different shape and/or or different dimension, in at least one cross section plane (i.e. in a XY, YZ, XZ plane), than the shape and/or the dimension of said electric charge collecting structures 12b-12f.

In an embodiment the photovoltaic device 1, comprises at least 2 fiducials 10, 10' having a different shaped cross section in at least one plane parallel to said horizontal X-Y plane.

In an embodiment illustrated in Fig.3: at least one fiducial 10, 10' has a conical shape defined in at least one plane orthogonal to said horizontal X-Y plane.

In an embodiment at least one of said fiducials 10 is made of a plurality of dots forming a pattern.

In an embodiment, illustrated in Fig.7, a third layer 50, which is preferably an at least partial transparent silicon layer 50, covers the photovoltaic structures 12a-12f and the interstitial portions 5a-5f of the intrinsic amorphous layer 5. This additional silicon layer 50 has a doping of the other type than the amorphous layer portion 2a, 2g and the nano-crystalline layer portion 4a, 4g.

As illustrated in Fig.7, said third layer 50 is a blanket layer and its deposition provides a plurality of third layer portions 50a-50e separated by third layer interstices. Said third layer portions 50a-50e have in practice the form of beams, defied also as fingers, arranged in an X-Y plane. The portion 50a, 50e of the third layer coating 50 that are on top of the fiducial mark structures 12a, 12g form coated fiducial marks 50a, 50g that has a reflectivity R3 different than the reflectivity R2 of said third layer interstices, as illustrated in Fig.7. Because of the difference between the optical reflectivity R1 of the fiducial marks 10 and the reflectivity R0 of the interstitial portions 5a-5f of the intrinsic amorphous layer 5, as described above, the fiducial marks 10 are optically easily detectable by optical means through said additional silicon layer 50,

The fiducial mark can still be detected through a further layer, also defined as second layer 60, deposited on said third layer 50. Said further layer 60 is typically a transparent and conductive layer, such as a TCO layer, as described hereafter. Furthermore, there may be a difference in reflectivity R3 and R2 after the deposition of said additional silicon layer 50a-50e so that the fiducial mark can be even more easily detected through said conductive and transparent layer 60.

Typical preferred thicknesses of the different layers 2, 4, 5 ,50, 60 are:
- the intrinsic amorphous silicon layer a-Si:H(i) layer 5: 2nm to 10nm, preferably 3nm.
- the first patterned silicon layer 2: 5nm to 15nm, preferably 11nm.
- second patterned nano-crystalline silicon layer 4: 15nm to 50nm, preferably 25nm.
- the third layer 50: 10nm to 40nm, preferably 20nm.
- the transparent and conductive second layer 60: 30nm to 300nm, preferably 50nm.

In embodiments, the absolute value of (R3-R2)/R2 may be between 0.001 and 0.5, preferably between 0.005 and 0.1, more preferable between 0.09 and 0.2. In practice a difference of some % between the values of R3 and R2 allows to provide optical detection of the presence of the fiducial marks 10, 10' in the device 1 of the invention. The invention is not limited to the exemplary value ranges of R3 and R2 as explained above.

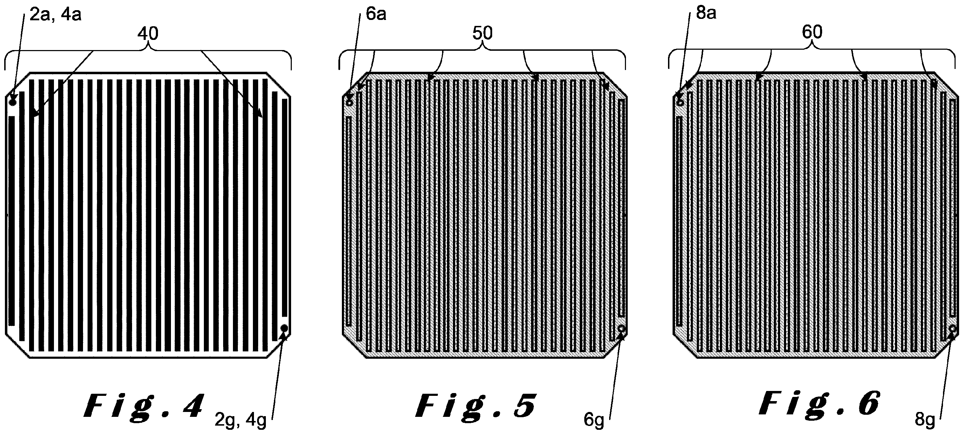

In an embodiment the second additional layer 60, arranged on said additional silicon layer 50, is a transparent conductive layer, that may be a full area layer, made at least partially of for example ZnO:Al. or ITO (Indium Tin oxide) Fig. 6 shows that the fiducials 10 of the invention are optically detectable through the second additional layer 60 and before its patterning, by using the fiducials in the way as described further in detail in the method section.

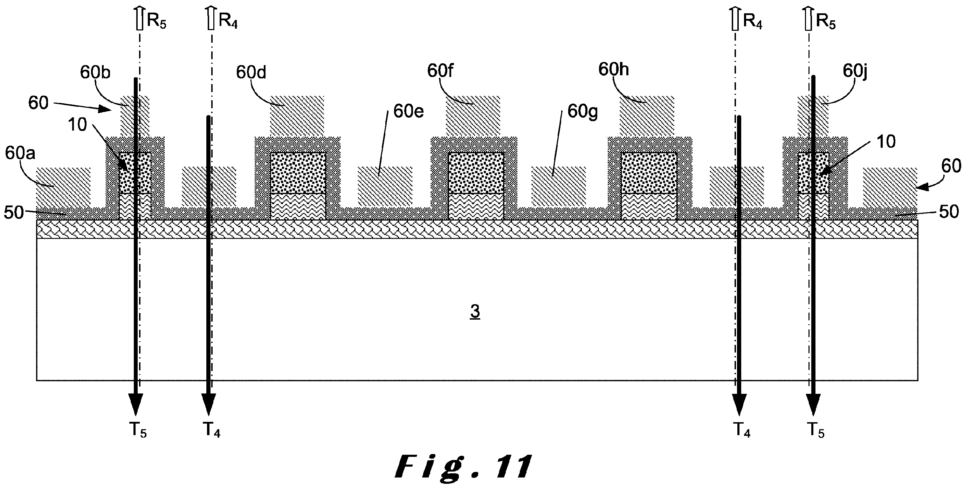

Fig.8 shows a conductive and transparent layer after the patterning step of a full area conductive and transparent layer (Fig.5) by using the alignment fiducials 10 of the invention. Fig.8 illustrates typical realization of a back-contact of the device of the invention. As illustrated in Fig.8 and Fig.11 , a first portion 60b, 60d, 60f, 60h, 60j of the structures are configured to extract negative charges, and the other portion 60a,60c,60e,60g, 60i are configured to extract positive charges upon incidence of light from the side of the substrate 3.

It is evident for electrical reasons that the portions of layer 60 (figure 9) must not connect the charge collecting structures having opposite polarities.

The invention provides also a complete solar cell that comprises preferably a metallization layer deposited on the Transparent Conductive Oxide layer. This may be realized by for example screen printing silver.

Like the third layer 50, the second additional layer 60 form with said photovoltaic structures and the third layer 50 structures that may have the form of beams or mesas 60a-60j. The portion 60a, 60e of the third layer coating 50 that are on top of the second additional layer 60 forms at least one coated fiducial mark 60a, 60g that has a reflectivity R5 different than the reflectivity R4 of its surrounding areas, as illustrated in Fig.8. Because of the difference between the optical reflectivity R3 of the coated fiducial marks 10 and the reflectivity R2 of the interstitial portions of the third layer 50, as described above, the fiducial marks 10 are still optically detectable by optical means through said second additional layer 60.

In embodiments the absolute value of (R5-R4)/R4 may be between 0.001 and 0.5, preferably between 0.005 and 0.1, more preferable between 0.09 and 0.2. In practice a difference of some % between the values of R5 and R4 allows to provide optical detection of the presence of the fiducial marks 10, 10' in the device 1 of the invention. The invention is not limited to the exemplary value ranges of R5 and R4 as explained above.

In embodiments at least two of the reflectivity values R1, R3, R5 may be identical. In other embodiments at least two of the interstice reflectivity values R0, R2, R4 may be identical.

Figs 4-6 show a top view on a horizontal cross section of a full wafer comprising:
- in Fig.4: the first patterned silicon layer 2 on which said second patterned nano-crystalline silicon layer 4 is deposited;
- in Fig.5 said third, semiconductor, layer 5 on top of the whole area covered with said second patterned nano-crystalline silicon layer 4;
- in Fig 6 a transparent and conductive layer 60 on top of said third layer 50.

It may be seen from the Figs. 5 and 6 that the fiducial marks 10 (i.e. said layers 4a and 4g on top of said layers 2a and 4g) are visible through the third layer 50 that is a full semiconductor layer, and also visible through said transparent and conductive layer 60 on top of said third layer 50.

In embodiments, the shape of the top of said fiducials 10 may be altered before depositing said third layer 50 and consequently said transparent and conductive layer 60.

In embodiments, illustrated in Fig.9 at least one fiducial mark 10 of the invention may remain non coated with said third layer 50 and/or said transparent and conductive layer 60. In the variant of Fig.9 the third coating layer 50 is not covering the fiducial marks and is not contact with two fiducial marks 10 and presents a gap G between the fiducial marks 10 and the third layer 50. The width of the gap G may be between 500µm to 1mm. This configuration can be useful in case that the third coating layer 50 or transparent conductive layer 60 is deposited using a specific bottom-top plasma deposition approach instead of a classical top-bottom plasma deposition approach. In this specific case, the solar cell is positioned down on an open tray facing a plasma deposition device and the wafer edges and the fiducials 10 are shaded by the tray during the plasma deposition.

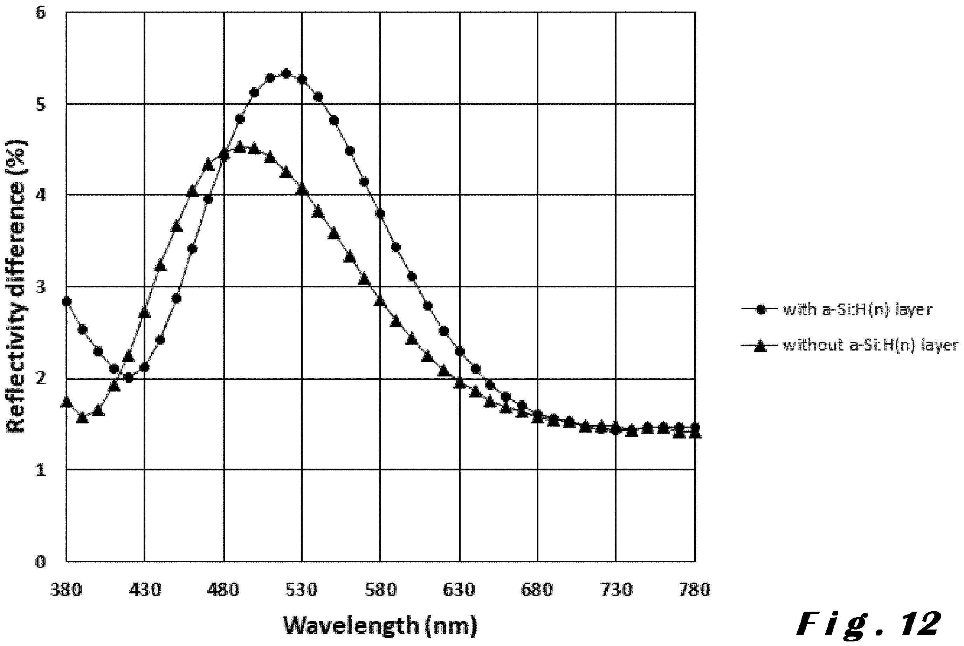

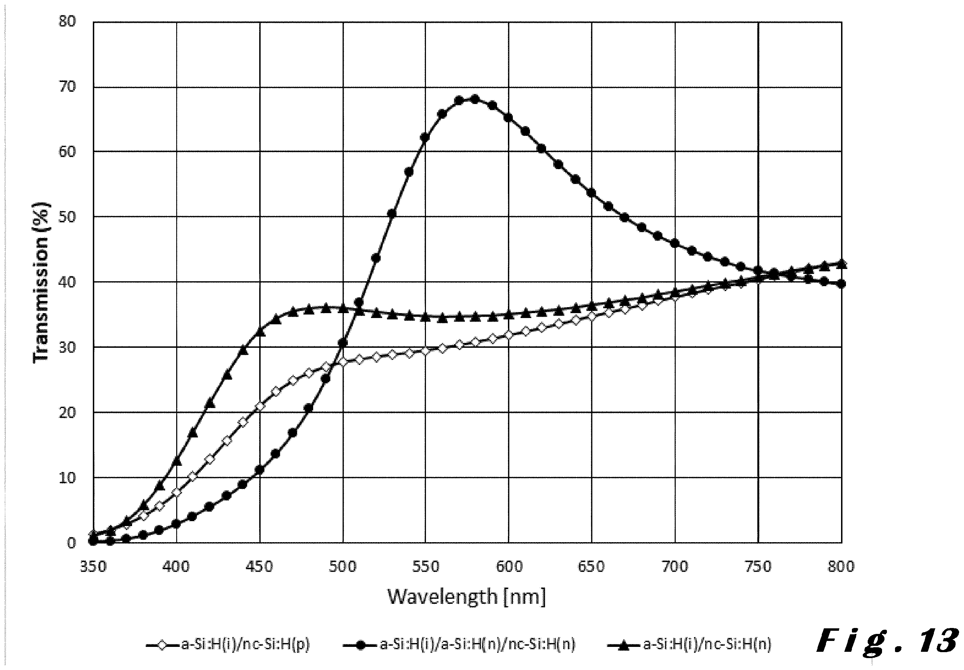

As illustrated in Figs. 12 and 13 the optical transmission T1 of the fiducial marks 10 may be greater or smaller than the optical transmission T0 of the interstitial portions 5a-5f of the intrinsic amorphous layer 5.

In embodiments the absolute value of (T1-T0)/T0 may be between 0.001 and 0.5, preferably between 0.005 and 0.1, more preferable between 0.09 and 0.2, optical transmission T0 and T1 being defined for a wavelength range between 300nm and 1000nm. In practice, a difference of some % between the values of T1 and T0 is sufficient to provide optical detection of the presence of the fiducial marks 10, 10' in the device 1 of the invention. The difference in optical transmission may be used in, for example, configurations wherein an infrared camera is used to detect the fiducials through a substrate that may be an at least partial optically transparent substrate. The invention is not limited to substrates made in Si.

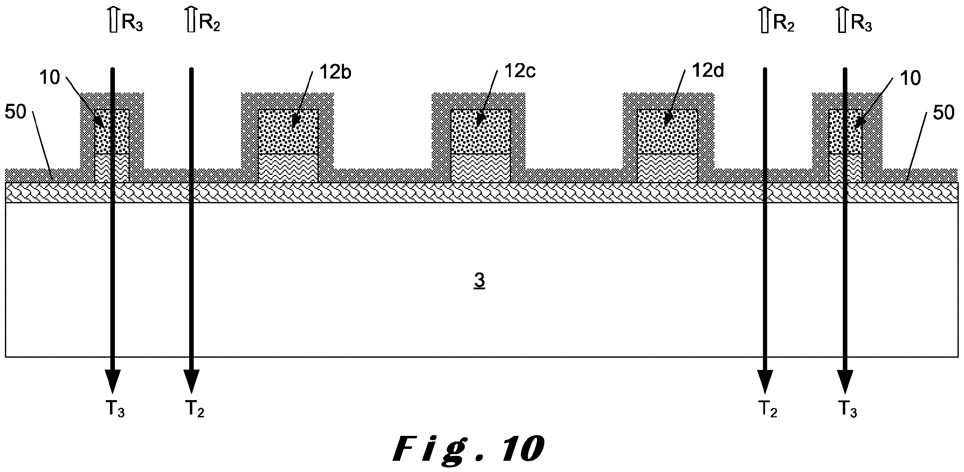

Similar to the transparency properties of the non -coated fiducials, coated fiducials may have also different transparencies relative to their interstices as illustrated in Figs. 10 and Fig.11, i.e. T3 is different than T2 and T5 is different than T4. In specific variants, transparencies differences T2-T0, T3-T2, T5-T4 do not exclude that reflectivities, as described above, may be the same: i.e. R1=R0;R3=R2;R5=R4.

The invention is also achieved by a photovoltaic cell comprising the photovoltaic device as described.

The invention is also achieved by a method for manufacturing of a photovoltaic device. The method comprises the **steps a-d** of:
**a.** providing a silicon-based substrate 3 having an n-type or a p-type doping and comprising an intrinsic amorphous a-Si:H(i) layer 5 situated on a first face 3a of said silicon-based substrate 3;
**b.** realizing, on said intrinsic layer 5, a first deposition of an n-type or p-type amorphous silicon layer 2, so as to create a patterned amorphous silicon layer 2 comprising a plurality of distinct and separated amorphous layer islands 2a-2g through a mask separated by interstices 2a'-2'g;
c. realizing, preferably by using the same mask, on each of said amorphous layer islands 2a-2g a second deposition of a nano-crystalline layer 4 having the same doping type as said amorphous layer 2, so as to create on top of each of said amorphous layer islands 2a-2g, nano-crystalline layer portions 4a-4g, to form an array of photovoltaic structures 12a-12f. The realization of said amorphous layer islands 2a-2g is made by choosing the thickness of said first amorphous layer portions 2a-2g so that at least one fiducial 10 is formed that has a different optical reflectivity R1, defined to the side away from said substrate 3, than the reflectivity R0 of the said interstices 2a'-2g'.

In an embodiment a further **step d** may comprise the following deposition: a semiconductor layer 50 having a doping type different than the doping type of said second nano-crystalline layer 4 is arranged on top of said photovoltaic structures 12a-12f and said interstices 5a-5f, so that said at least one fiducial 10, 10' may be detected by optical means through said semiconductor layer 50 that is preferably a full area layer 50.

In an embodiment, after said **step d** of realizing a full semiconductor layer 50, a **step e** is realized consisting in depositing a second area layer 60 on top of said full first area layer 50 and so that said at least one fiducial 10, 10' may be detected by optical means through said first full area layer 50 and said second full area layer 60. Said second area layer 60 may be a full area layer. Said full first area layer 50 has a preferred thickness in a range of 15 to 40nm.In an advantageous embodiment said second area layer 60 is an at least transparent and conductive layer such as a ZnO:Al. or an ITO (Indium Tin oxide) layer

In an embodiment, the thickness t2 of second full area layer 60 is chosen so that, by constructive interference, reflected light off said at least one fiducial 10,10' is transmitted through said second full area layer 60 in at least one wavelength range defined in the UV, visible or infrared optical spectrum. Said full first area layer 60 has a preferred thickness in a range of 30-300nm. 13.

In an embodiment the optical properties of said at least one fiducial 10, 10' is determined during the fabrication process with an optical instrument.

Such an optical instrument may comprise a camera with image processing capabilities, or an interferometer that may comprise a laser. A monochrome camera using LEDs having a wavelength of the emitted light of 635nm may be used advantageously.

In an embodiment, illustrated in Fig.3, the realization of said at least one fiducial 10,10' is made by using a mask 100' comprising at least one conical shape aperture, said conical shape being defined in at least one plane orthogonal to said horizontal plane giving at least one fiducial 10, 10' which has a greater height h, defined in said Z-direction, than said electric charge collection structures 12b-12f.

In order to provide a full solar cell an additional **step f** is performed that consist in depositing a metallization layer on the ZnO layer. This may be made by for example screen printing silver.

It is generally understood that the process and device of the invention may be applied to photovoltaic cell that rely on non-silicon devices, e.g. devices based on other semiconductors such as Germanium (Ge) based photovoltaic cells

### Experimental results

Fig. 10 illustrates the difference in reflectivity of a photovoltaic device on top of a fiducial mark of the invention, comprising an amorphous a-Si:H(n) layer and of the area beside that fiducial that has no a-Si:H(n) layer. Fig.10 shows a typical required contrast of a fiducial 10 of the invention to allow its optical detection. The reflectivity curves of Fig.10 demonstrates the benefit of using a layer of a-Si:H(n) in the fiducials 10 of the invention for enhancing the contrast in the case of a typical visible spectrum .

Fig.11 illustrates the transmission difference between fiducials 10 that comprise an amorphous a-Si:H(n) layer and a fiducial that does not comprise an amorphous a-Si:H(n) layer.

## Claims

1. A photovoltaic device (1), being an interdigitated back contact (IBC) comprising:
- a silicon-based substrate (3) being of p-type or n-type doping and having a first face (3a) defining a horizontal X-Y plane and a vertical direction Z orthogonal to said horizontal X-Y plane;
- an intrinsic amorphous silicon layer a-Si:H(i) (5) situated on said first face (3a);
- a first patterned silicon layer (2), situated on said intrinsic amorphous silicon layer a-Si:H(i) layer (5), comprising a first array of distinct and separated amorphous layer islands (2a-2g) so that between the amorphous layer islands (2a-2g) non-coated intrinsic amorphous silicon (a-Si:H(i)) layer portions (5a-5f) are provided that define an array (2') of interstices (2a'-2g'), said first patterned silicon layer (2) having the same doping as the doping of the silicon-based substrate (3),
- a second patterned nano-crystalline silicon layer (4) in contact with said first patterned silicon layer (2), comprising a second array of second layer portions (4a-4g), each of said second layer portions (4a-4g) being in contact with one of said first layer portions (2a-2g) and forming an array (40) of photovoltaic structures (12a-12g),
wherein
said second array of second layer portions (4a-4g) is of the same type of doping than said first patterned silicon layer (2),
and wherein at least one of said photovoltaic structures (12a, 12g), constitutes a fiducial mark (10) having, in a predetermined wavelength range, a different optical reflectivity (R1), defined to the side away from said substrate (3), than the reflectivity (R0) of said intrinsic amorphous silicon (a-Si:H(i)) layer portions (5a-5f).

2. The photovoltaic device (1) according to claim 1, wherein the absolute value of (R1-R0)/R0 is between 0.001 and 0.5, preferably between 0.005 and 0.1, more preferable between 0.09 and 0.2 for at least one wavelength, said optical reflectivities R0, R1 being defined for wavelengths between 300nm and 1000nm.

3. The photovoltaic device (1) according to claim 1 or claim 2, comprising at least two fiducials (10, 10').

4. The photovoltaic device (1) according to any one of claims 1 to 3 wherein at least one of said fiducials (10,10') has a different shape and/or or different dimension, in at least one cross section plane (XY, YZ, XZ), than the shape and/or the dimension of said electric charge collecting structures (12b-12f).

5. The photovoltaic device (1) according to claim 3 or claim 4, comprising at least 2 fiducial marks (10, 10') having a different shaped cross section in at least one plane parallel to said horizontal X-Y plane.

6. The photovoltaic device (1) according to any one of claims 1-5 wherein an additional silicon layer (50) is present on said second patterned nano-crystalline silicon layer (4), covering said photovoltaic structures (12 a-12f) and said interstices (5a-f), said additional silicon layer (50) having a doping of the other type than said first patterned silicon layer (2), the mesa (50a) on said at least one fiducial (10) having a different reflectivity R3 than the reflectivity R2 of said interstices (5a-f) so that said at least one fiducial (10) is optically detectable by optical means through said additional silicon layer (50).

7. The photovoltaic device (1) according to any one of claims 1-6 wherein a transparent and conductive second layer (60), is present on said additional silicon layer (50), second layer (60) covering said mesas (50a- 50g) and said third layer interstices (50b-50f) so that the at least one coated fiducial (50a, 50g) has a reflectivity R5 different than the reflectivity R4 of its surroundings and so that said at least one coated fiducial(10) is optically detectable by optical means through said additional silicon layer (50) and said second layer (60).

8. A photovoltaic cell comprising the photovoltaic device (1) according to any one of claims 1 to 7.

9. Method for manufacturing of a photovoltaic device (1) according to any one of claims 1 to 7, comprising the steps **(a-d)** of:
**a.** providing a silicon-based substrate (3) having an n-type or a p-type doping and comprising an intrinsic amorphous a-Si:H(i) layer (5) situated on a first face (3a) of said silicon-based substrate (3);
**b.** realizing, on said intrinsic layer (5), a first deposition of an n-type or p-type amorphous silicon layer (2), so as to create a patterned amorphous silicon layer (2) comprising a plurality of distinct and separated amorphous layer islands (2a-2g) separated by interstices (2a'-2'g);
**c.** realizing on each of said amorphous layer islands (2a-2g) a second deposition of a nano-crystalline layer (4) having the same doping type as said amorphous layer (2), so as to create on top of each of said amorphous layer islands (2a-2g), nano-crystalline layer portions (4a-4g), to form an array of photovoltaic structures (12a-12f), while choosing the thickness (t) of said first amorphous layer portions (2a-2g) so that at least one fiducial (10) is formed that has a different optical reflectivity (R1), defined to the side away from said substrate (3), than the reflectivity (R0) of the said intrinsic amorphous silicon (a-Si:H(i)) layer portions (5a-5f).

10. Method according to claim 9 wherein the deposition of said amorphous layer islands (2a-2g) and the deposition of the nano-crystalline layer islands (4a-4g) are made through the same mechanical mask.

11. Method according to claim 9 or 10, wherein, after **step c, a step d** is performed consisting in depositing, on top of the photovoltaic structures 12a-12f said intrinsic amorphous silicon (a-Si:H(i)) layer portions (5a-5f), a full area semiconductor layer (50), having a doping type different than the doping type of said second nano-crystalline layer (4) so that said at least one fiducial (10, 10') may be detected by optical means through said full area semiconductor layer (50)

12. Method according to claim 11, wherein after said **step d,** a **step e** is realized consisting in depositing a second layer (60) on top of said semiconductor layer (50) and so that said at least one fiducial (10,10') may be detected by optical means through said full area semiconductor layer **(50)** and second layer (60).

13. Method according to claim 12, wherein the thickness (t2) of said second layer (60) is chosen so that, by constructive interference, reflected light off said at least one fiducial (10, 10') is transmitted through said second layer (60), in at least one wavelength range defined in the UV, visible or infrared optical spectrum.

14. Method according to any one of claims 9 to 13, wherein the realization of said at least one fiducial (10, 10') is made by using a mask (100') comprising at least one conical shape aperture, said conical shape being defined in at least one plane orthogonal to said horizontal X-Y plane and so that at least one fiducial (10, 10') has a greater height (h) than said electric charge collection structures (12b-12f).
